# FASCICULE DE BREVET EUROPEEN

(11) **EP 4 291 446 B1**
(45) Date de publication et mention de la délivrance du brevet: **11.12.2024**
(21) Numéro de dépôt: 22703023.6
(22) Date de dépôt: 13.01.2022
(51) Int. Cl.: B60R 16/02, B60J 5/10

(54) **ÉLÉMENT DE CARROSSERIE COMPORTANT UNE SURFACE DE DISSIPATION DE COURANT ÉLECTRIQUE**
KAROSSERIEELEMENT MIT EINER OBERFLÄCHE ZUR ABLEITUNG VON ELEKTRISCHEM STROM
BODYWORK ELEMENT COMPRISING A SURFACE FOR DISSIPATING ELECTRIC CURRENT

(30) Priorité: 10.02.2021 FR 2101239
(43) Date de publication de la demande: 20.12.2023
(73) Titulaire: Stellantis Auto SAS, 78300 Poissy (FR); Flex-N-Gate France, 25405 Audincourt (FR)
(72) Inventeur: SIMON, Herve, 78990 ELANCOURT (FR); ROCH, Hervé, 25200 MONTBELIARD (FR)
(86) Numéro de dépôt international: PCT/FR2022/050075
(87) Numéro de publication internationale: WO 2022/171941

(56) Documents cités:
- DE-A1- 4 221 860
- FR-A3- 3 082 803
- JP-A- 2005 047 354
- JP-A- 2016 120 759

## Description

Le domaine technique concerne les éléments de carrosserie de véhicule automobile, notamment les volets de coffres arrière, comportant une surface conductrice à des fins de dissipation d'énergie électrique.

L'invention concerne également les véhicules équipés de tels éléments de carrosserie, comme par exemple décrit dans le document JP2016-120759.

Les équipements électriques installés à bord des véhicules modernes sont de plus en plus nombreux et diversifiés. Or ces derniers sont susceptibles d'être perturbés par des courants électriques indésirables, dont il convient de dissiper la plus grande quantité possible. Ainsi, les antennes radioélectriques et les nombreux amplificateurs font partie des équipements électriques à protéger les plus sensibles, afin notamment d'augmenter les qualités des systèmes audio embarqués.

Les solutions classiques pour éviter ou dissiper les courants électriques indésirables mettent en oeuvre des tresses métalliques, également appelée tresses de masse, qui relient les équipements électriques à protéger à la caisse métallique du véhicule. Ces solutions supposent la mise en oeuvre en particulier de charnières conductrices de courant électrique pour les articulations entre les pièces de carrosserie, pour assurer une continuité de la conductivité électrique. En effet, il est courant de disposer les équipements électriques à protéger dans les ouvrants et notamment le volet de coffre arrière.

Les constructeurs de véhicules automobiles utilisent de plus en plus de pièces de carrosserie en matériaux plastiques ou composites pour assembler leurs véhicules car ces matériaux présentent de nombreux avantages tels que des coûts de mise en oeuvre réduits, un gain de poids ou encore des possibilités accrues en termes de formes. Cependant, l'utilisation de tels pièces de carrosserie est susceptible de compliquer la dissipation des courants électriques indésirables. Pour pallier l'absence de conductivité électrique de telles pièces de carrosserie, les constructeurs d'automobiles ont pris l'habitude d'adjoindre des toiles métalliques lors du moulage des pièces de carrosserie. L'ajout de telles toiles métalliques représente un surcoût significatif et, dans certains cas, est simplement impossible.

Ainsi, il existe un besoin de solutions techniques permettant l'intégration de moyens de dissipation de courant électriques indésirables pour des véhicules comportant des pièces de carrosserie en matériau non conducteur d'électricité, tout en s'affranchissant des solutions classiques, exposées précédemment, trop complexes et coûteuses à mettre en oeuvre.

La présente invention a pour objet de pallier les problèmes exposés précédemment. Dans ce contexte technique, un but de la présente invention est de fournir un élément de carrosserie permettant de dissiper des courants électriques indésirables afin de protéger au moins un équipement électrique à protéger, tout en réduisant les coûts de fabrication.

A cet effet, la présente invention se rapporte à un élément de carrosserie d'un véhicule automobile comprenant une doublure définissant un volume interne destiné à être fermé par une peau extérieure, la doublure étant composée de matériau non conducteur d'électricité et l'élément de carrosserie comportant au moins deux éléments de structure interne disposés dans le volume interne, entre lesquels une surface conductrice de matériau conducteur d'électricité est étendue à distance de la doublure, de sorte à permettre la dissipation d'énergie électrique. L'invention concerne également un volet de coffre comportant un élément de carrosserie selon l'invention, comprenant une peau extérieure assemblée sur la doublure.

L'invention concerne enfin un véhicule comportant un volet de coffre selon l'invention.

Ainsi, l'élément de carrosserie selon l'invention permet d'obtenir un volet de coffre qui est capable de dissiper tout ou partie d'un courant électrique indésirable même si l'élément de carrosserie est composé de matériau non conducteur d'électricité. En effet, La surface conductrice, disposée dans l'espace interne de la doublure, est capable de dissiper au moins en partie un courant électrique indésirable. Or, les courants électriques indésirables sont susceptibles de générer des parasites électromagnétiques. Par un élément de carrosserie composé de matériau non conducteur il est entendu que l'élément de carrosserie selon l'invention est composé indifféremment d'un ou de plusieurs matériaux.

Par ailleurs, il est aisé de fixer, notamment par collage, la surface conductrice en l'étendant entre au moins deux des éléments de structure interne. De ce fait, en étendant la surface conductrice entre deux éléments de structure interne, il n'est pas nécessaire de recourir à l'adjonction d'une toile métallique au moment du moulage de la doublure. Ainsi, l'élément de carrosserie selon l'invention est simple et peu coûteux à produire et permet d'obtenir une surface conductrice suffisamment grande afin de dissiper tout ou partie d'un courant indésirable. Étendre une surface conductrice entre au moins deux éléments de structure interne, à distance de la doublure, permet de s'affranchir des formes et volumes complexes de la doublure.

Selon un mode de réalisation de l'invention, au moins un des éléments de structure interne est une nervure de renforcement de la doublure. La présence d'une ou plusieurs nervures est fréquente dans les doublures destinées à des pièces de carrosserie, de sorte que peu ou pas de modifications sont nécessaires pour obtenir un élément de carrosserie selon l'invention à partir d'une doublure. Selon un mode de réalisation, la surface conductrice est composée d'au moins une feuille de matériau conducteur. Par matériau conducteur, il est entendu que la feuille peut être composée d'un ou de plusieurs matériaux. Une feuille de matériau conducteur d'électricité est simple à étendre et à fixer entre deux éléments de structure interne. De plus, une feuille de matériau conducteur, notamment une feuille métallique telle qu'une feuille d'aluminium est facilement disponible et peu coûteuse. Avantageusement le film métallique est tendu entre les deux éléments de structure interne : lors du montage l'opérateur doit simplement tendre le film et l'apposer sur les éléments de structure interne pour le fixer, par exemple le coller.

Avantageusement, chaque feuille de matériau conducteur est un film métallique renforcé par un film de matière plastique. Un tel film plastique permet de renforcer le film métallique et ainsi éviter tout déchirement lors de l'assemblage de l'élément de carrosserie ou du volet de coffre.

Selon un mode de réalisation, la surface conductrice est électriquement connectée à au moins une languette destinée à assurer une continuité électrique entre la surface conductrice et au moins un équipement électrique à protéger d'un courant électrique indésirable. Chaque languette sert à connecter électriquement, directement ou indirectement l'équipement électrique à protéger à la surface conductrice pour permettre d'acheminer un courant électrique indésirable vers la surface conductrice.

Avantageusement, au moins une languette s'étend à travers la doublure.

Selon un mode de réalisation, la peau extérieure est collée sur une zone d'encollage disposée sur un pourtour de la doublure et est distincte des éléments de structure interne. Ainsi, la surface conductrice se retrouve en suspension dans l'espace interne, entre la doublure et la peau extérieure du volet de coffre. L'invention sera mieux comprise à la lecture de la description détaillée qui va suivre, donnée uniquement à titre d'exemple non limitatif et faite en se référant aux dessins annexés sur lesquels :
[Fig. 1] la figure 1, représente une vue en perspective d'une doublure utilisée pour obtenir un élément de carrosserie selon l'invention et illustre des éléments de structure interne utilisés pour former l'élément de carrosserie selon l'invention ;
[Fig. 2] la figure 2, représente une vue en perspective d'un élément de carrosserie obtenu à partir de la doublure représentée sur la figure 1 ;
[Fig. 3] la figure 3, représente une vue en coupe longitudinale suivant un axe AA, représenté sur les figures 1 et 2, d'un volet de coffre obtenu à partir de l'élément de carrosserie représenté sur la figure 2 ;

Dans ces figures, les mêmes références sont utilisées pour désigner les mêmes éléments.

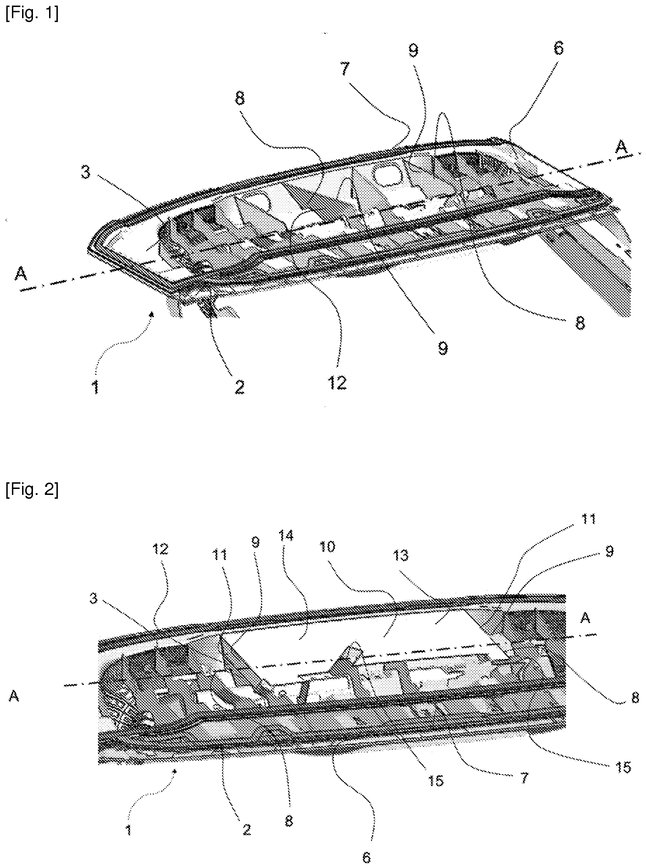

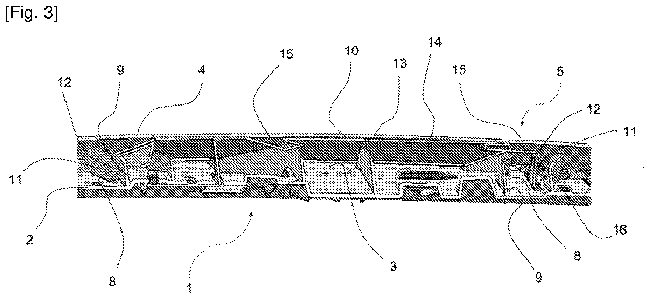

Un élément de carrosserie 1 selon l'invention, représenté à la figure 2, comprend une doublure 2, représentée sur les figures 1 et 2, qui définit un volume interne 3 destiné à être fermé par une peau extérieure 4, représentée sur la figure 3. La doublure 2 avec la peau extérieure 4 fixée, par exemple, par collage sur la doublure 2 forment un volet 5 de coffre, représenté sur la figure 3, notamment un volet 5 de coffre arrière d'un véhicule automobile selon l'invention, non représenté sur les figures. La doublure 2 et le volet 5 présentent une extension longitudinale suivant un axe AA, représenté sur les figures 1 et 2. Afin d'assembler la peau extérieure 4 sur la doublure 2, cette dernière présente une zone d'encollage 6 disposée sur un pourtour de la doublure 2. Lors de l'assemblage, un cordon de colle 7 est ainsi disposé sur la doublure 2 puis la peau extérieure 4 est pressée contre le cordon de colle 7. La doublure 2 est composée de matériau non conducteur d'électricité. Il est précisé que la doublure 2 est constituée indifféremment d'un ou de plusieurs matériaux non conducteurs. Par exemple, la doublure 2 est composée d'un ou de plusieurs plastiques. L'élément de carrosserie 1 selon l'invention comporte en outre au moins deux éléments de structure interne 8, représentés sur la figure 1, disposés dans le volume interne 3. Les éléments de structure interne 8 font partie intégrante de la doublure 2 sur l'exemple représenté sur les figures mais pourraient également être rapportés sur celle-ci par collage et/ou tout autre moyen de fixation. Dans l'exemple illustré sur la figure 1, chaque élément de structure interne 8 forme une nervure 9 destinée à renforcer la doublure 2.

L'élément de carrosserie 1 selon l'invention comporte également une surface conductrice 10 formée d'un matériau conducteur d'électricité, visible sur les figures 2 et 3, conçue pour dissiper toute ou partie d'un courant électrique la parcourant. Il est entendu que la surface conductrice 10 est constituée indifféremment d'un ou de plusieurs matériaux. Cette surface conductrice 10 s'étend entre au moins deux des éléments de structure interne 8, à distance de la doublure 2 entre lesdits éléments de structure interne 8. La surface conductrice 10 est fixée sur les éléments de structure interne 8. Cette fixation de la surface conductrice 10 est obtenue par exemple par collage. A cet effet, la surface conductrice 10 présente avantageusement des rabats 11, visibles sur les figures 2 et 3, rabattus sur une face latérale 12 des éléments de structure interne 8, dont l'une est visible sur la figure 2, afin d'améliorer la fixation de la surface conductrice 10 sur les éléments de structure interne 8. Cette surface conductrice 10 est facilement formée à l'aide d'une feuille 13 de matériau conducteur, en particulier par un film métallique 14. A cet effet, un film d'aluminium est particulièrement adapté pour former la surface conductrice 10. Avantageusement, le film métallique 14 formant la surface conductrice 10 est renforcé par un film de matière plastique collé sur le film métallique 14. Un tel renforcement à l'aide d'un film de matière plastique permet d'éviter le déchirement du film métallique 14 lors de l'assemblage de l'élément de carrosserie 1. Pour une protection optimale du film métallique 14, le film plastique recouvre intégralement une face du film métallique 14. Avantageusement le film métallique 14 est tendu entre les éléments de structure interne 8.

De façon avantageuse, la surface conductrice 10 est électriquement connectée à au moins une languette 15 destinée à assurer une continuité électrique entre la surface conductrice 10 et au moins un équipement électrique, non représenté sur les figures, qui doit être protégé d'un courant électrique indésirable généralement source de parasites électromagnétiques. Ainsi, chaque languette 15 permet d'acheminer un courant électrique indésirable depuis un équipement électrique à protéger vers la surface conductrice 10 qui contribue à le dissiper au moins en partie. Dans l'exemple illustrée sur les figures, l'élément de carrosserie 1 comporte deux languettes 15. Avantageusement, les languettes 15 sont formées par une extension de la surface conductrice 10. En cas de besoin, notamment lorsque l'équipement électrique à protéger est disposé en dehors du volume interne 3, au moins une languette 15 s'étend à travers la doublure 2 par exemple par des orifices 16, dont un est représenté sur la figure 3, ménagés à cet effet dans la doublure 2.

Ainsi, l'élément de carrosserie 1 selon l'invention permet d'obtenir un volet 5 de coffre capable de dissiper tout ou partie d'un courant électrique indésirable grâce à la surface conductrice 10, même si l'élément de carrosserie 1 est composé de matériau(x) non conducteur(s) d'électricité. La surface conductrice 10, disposée dans l'espace interne 3 de la doublure 2, permet une implantation simple malgré la taille et la complexité du volume interne 3. La procédure pour assembler un élément de carrosserie 1 est simple et représente un gain économique appréciable.

Comme illustré sur la figure 3, pour former le volet 5 de coffre selon l'invention, la peau extérieure 4 est collée sur la zone d'encollage 6 préférablement distincte des éléments de structure interne 8, de sorte à ce que le film métallique 14 est également étendu à distance de la peau extérieure 4.

L'invention ne se limite pas au mode de réalisation de l'élément de carrosserie 1 ou du volet 5 de coffre décrit ci-avant, seulement à titre d'exemple, mais d'autres modes de réalisation peuvent être conçus par l'homme de métier sans sortir du cadre et de la portée de la présente invention.

## Revendications

1. Élément de carrosserie (1) d'un véhicule automobile comprenant une doublure (2) définissant un volume interne (3) destiné à être fermé par une peau extérieure (4), la doublure (2) étant composée de matériau non conducteur d'électricité et l'élément de carrosserie (1) comportant au moins deux éléments de structure interne (8) disposés dans le volume interne (3), entre lesquels une surface conductrice (10) de matériau conducteur d'électricité est étendue à distance de la doublure (2), de sorte à permettre la dissipation d'énergie électrique.

2. Élément de carrosserie (1) selon la revendication 1, **caractérisée en ce que** au moins un des éléments de structure interne (8) est une nervure (9) de renforcement de la doublure (2).

3. Élément de carrosserie (1) selon la revendication 1 ou 2, **caractérisée en ce que** la surface conductrice (10) est composée d'au moins une feuille (13) de matériau conducteur.

4. Élément de carrosserie (1) selon la revendication 3, **caractérisée en ce que** chaque feuille (13) de matériau conducteur est un film métallique (14) renforcé par un film de matière plastique.

5. Élément de carrosserie selon l'une des revendications 1 à 4, **caractérisée en ce que** la surface conductrice (10) est électriquement connectée à au moins une languette (15) destinée à assurer une continuité électrique entre la surface conductrice (10) et au moins un équipement électrique à protéger d'un courant électrique indésirable.

6. Élément de carrosserie (1) selon la revendication 5, **caractérisée en ce que** au moins une languette (15) s'étend à travers la doublure (2).

7. Volet (5) de coffre comportant un élément de carrosserie (1) selon l'une des revendications 1 à 6, comprenant une peau extérieure (4) assemblée sur la doublure (2).

8. Volet (5) selon la revendication 7, **caractérisé en ce que** la peau extérieure (4) est collée sur une zone d'encollage (6) disposée sur un pourtour de la doublure (2) et est distincte des éléments de structure interne (8).

9. Véhicule **caractérisé en ce qu'**il comporte un volet (5) de coffre selon la revendication 7 ou 8.

## Patentansprüche

1. Karosserieteil (1) eines Kraftfahrzeuges mit einer Auskleidung (2), die ein Innenvolumen (3) zum Verschließen durch eine Außenhaut (4) definiert, wobei die Auskleidung (2) aus elektrisch nicht leitendem Material besteht und das Karosserieteil (1) mindestens zwei innere Strukturelemente (8) aufweist, die in dem Innenvolumen (3) angeordnet sind, zwischen denen eine leitende Oberfläche (10) aus elektrisch leitendem Material in einem Abstand von der Auskleidung (2) ausgedehnt ist, sodass elektrische Energie abgeführt werden kann.

2. Karosserieteil (1) nach Anspruch 1, **dadurch gekennzeichnet, dass** mindestens eines der inneren Strukturelemente (8) eine Verstärkungsrippe (9) der Auskleidung (2) ist.

3. Karosserieteil (1) nach Anspruch 1 oder 2, **dadurch gekennzeichnet, dass** die leitende Oberfläche (10) aus mindestens einer Folie (13) aus leitendem Material besteht.

4. Karosserieteil (1) nach Anspruch 3, **dadurch gekennzeichnet, dass** jede Folie (13) aus leitendem Material eine Metallfolie (14) ist, die durch eine Kunststofffolie verstärkt ist.

5. Karosserieteil nach einem der Ansprüche 1 bis 4, **dadurch gekennzeichnet, dass** die leitende Oberfläche (10) elektrisch mit mindestens einer Zunge (15) verbunden ist, die dazu bestimmt ist, eine elektrische Kontinuität zwischen der leitenden Oberfläche (10) und mindestens einer elektrischen Einrichtung zu gewährleisten, die vor einem unerwünschten elektrischen Strom zu schützen ist.

6. Karosserieteil (1) nach Anspruch 5, **dadurch gekennzeichnet, dass** sich mindestens eine Zunge (15) durch die Auskleidung (2) erstreckt.

7. Kofferraumklappe (5) mit einem Karosserieteil (1) nach einem der Ansprüche 1 bis 6, mit einer auf der Auskleidung (2) montierten Außenhaut (4).

8. Klappe (5) nach Anspruch 7, **dadurch gekennzeichnet, dass** die Außenhaut (4) auf einen an einem Umfang des Futters (2) angeordneten Klebebereich (6) aufgeklebt und von den inneren Strukturelementen (8) getrennt ist.

9. Fahrzeug, **dadurch gekennzeichnet, dass** es eine Kofferraumklappe (5) nach Anspruch 7 oder 8 aufweist.

## Claims

1. A bodywork element (1) of a motor vehicle comprising a lining (2) defining an inner volume (3) to be closed by an outer skin (4), the lining (2) being composed of electrically non-conductive material and the bodywork element (1) comprising at least two internal structural elements (8) arranged in the inner volume (3), between which a conductive surface (10) of electrically conductive material is extended at a distance from the lining (2), so as to allow the dissipation of electrical energy.

2. Bodywork element (1) according to claim 1, **characterized in that** at least one of the internal structural elements (8) is a rib (9) for reinforcing the lining (2).

3. Bodywork element (1) according to claim 1 or 2, **characterized in that** the conductive surface (10) is composed of at least one sheet (13) of conductive material.

4. Bodywork element (1) according to claim 3, **characterized in that** each sheet (13) of conductive material is a metal film (14) reinforced by a film of plastic material.

5. Bodywork element according to one of claims 1 to 4, **characterized in that** the conductive surface (10) is electrically connected to at least one tongue (15) intended to ensure electrical continuity between the conductive surface (10) and at least one piece of electrical equipment to be protected from an undesirable electrical current.

6. Bodywork element (1) according to claim 5, **characterized in that** at least one tongue (15) extends through the lining (2).

7. Trunk flap (5) comprising a bodywork element (1) according to one of claims 1 to 6, comprising an outer skin (4) assembled on the lining (2).

8. Flap (5) according to claim 7, **characterized in that** the outer skin (4) is glued to a gluing zone (6) arranged on a periphery of the lining (2) and is distinct from the elements of internal structure (8).

9. Vehicle **characterized in that** it comprises a trunk flap (5) according to claim 7 or 8.
